# FASCICULE DE BREVET EUROPEEN

(11) **EP 1 388 174 B1**
(45) Date de publication et mention de la délivrance du brevet: **25.07.2007**
(21) Numéro de dépôt: 02738274.6
(22) Date de dépôt: 17.05.2002
(51) Int. Cl.: H01L 31/0203, H01L 31/0232

(54) **BOITIER BLINDE POUR UN COMPOSANT SEMI-CONDUCTEUR OPTIQUE**
UNDURCHLÄSSIGES GEHÄUSE FÜR EIN OPTISCHES HALBLEITERBAUELEMENT
SHIELDED HOUSING FOR OPTICAL SEMICONDUCTOR COMPONENT

(30) Priorité: 18.05.2001 FR 0106552
(43) Date de publication de la demande: 11.02.2004
(73) Titulaire: STMicroelectronics S.A., 92120 Montrouge (FR)
(72) Inventeur: EXPOSITO, Juan, F-38330 St Nazaire les Eymes (FR); BRECHIGNAC, Rémi, F-38000 Grenoble (FR); VITTU, Julien, Résidence de l'Europe, F-38019 Grenoble Cedex (FR)
(74) Mandataire: Casalonga, Axel
(86) Numéro de dépôt international: PCT/FR2002/001690
(87) Numéro de publication internationale: WO 2002/095837

(56) Documents cités:
- DE-A- 19 527 026
- US-A- 5 150 180
- US-A- 5 542 988
- US-A- 5 981 945

## Description

La présente invention concerne le domaine des boîtiers semi-conducteurs optiques.

Dans l'état de la technique, de tels boîtiers comprennent une cavité étanche dans laquelle est fixé un composant semi-conducteur optique dont une face avant présente un capteur optique, la cavité étant délimitée en partie par une vitre s'étendant en avant de ce capteur optique. Il est en outre connu de fixer, à l'extérieur de la cavité et sur la vitre, un porte-lentille munie d'une lentille placée en face du capteur optique.

Le brevet US-A-5 150 180 décrit un boîtier qui comprend un anneau métallique entourant une vitre, empêchant les radiations d'atteindre un capteur optique placé en arrière.

Le document US 5,542,988 décrit un boitier pour des cellules solaires avec moyens de blindage électromagnetique.

Néanmoins, les composants semi-conducteurs optiques étant sensibles à des champs électromagnétiques, de tels boîtiers délivrent des signaux électriques perturbés par de tels champs.

La présente invention a pour but de proposer un boîtier semi-conducteur optique améliorant la qualité des signaux électriques qu'il doit délivrer.

D'une manière générale, le boîtier semi-conducteur optique selon l'invention comprend un composant semi-conducteur optique dont une face avant présente un capteur optique et des moyens d'encapsulation comprenant un support et un couvercle disposé sur une face frontale de ce support, qui délimitent entre eux ladite cavité dans laquelle est disposé ledit composant optique dont la face arrière est fixée sur ledit support, et présente des moyens de connexion électrique extérieure de ce composant semi-conducteur optique, ledit couvercle comprenant une vitre laissant passer la lumière vers ledit capteur optique. Lesdits moyens d'encapsulation comprennent des moyens de blindage électromagnétique en un matériau conducteur de l'électricité, ces moyens de blindage étant isolés électriquement des moyens de connexion électrique dudit composant optique, une zone desdits moyens d'encapsulation située en face dudit capteur optique étant exempte de moyens de blindage électromagnétique afin de laisser passer la lumière vers ce capteur.

Selon l'invention, lesdits moyens de blindage sont reliés à des moyens de connexion électrique extérieure et comprennent des parties de blindage portées par ledit support et des parties de blindage portées par ledit couvercle, ces parties de blindage étant reliées électriquement entre elles dans la zone de la face frontale dudit support.

Selon l'invention, lesdits moyens de blindage sont de préférence au moins en partie intégrés dans lesdits moyens d'encapsulation.

Selon l'invention, lesdits moyens de blindage peuvent avantageusement envelopper au moins en partie lesdits moyens d'encapsulation.

Selon l'invention, ledit couvercle vitré est de préférence fixé sur ledit support par une colle conductrice de l'électricité réalisant la liaison électrique entre eux.

Selon l'invention, ledit couvercle vitré peut avantageusement comprendre une vitre dont une face est recouverte au moins partiellement d'une couche ou une plaque de blindage en un matériau conducteur de l'électricité ménageant une ouverture située en face dudit capteur optique.

Selon l'invention, ledit couvercle vitré peut avantageusement comprendre une plaque en un matériau conducteur de l'électricité, qui présente une ouverture située en face dudit capteur optique et obstruée par ladite vitre.

Selon une autre variante de l'invention, lesdits moyens d'encapsulation comprennent un porte-lentille placé en avant dudit couvercle vitré, lesdits moyens de blindage comprenant de préférence des parties de blindage portées par ledit support et des parties de blindage portées par ledit porte-lentille.

Selon l'invention, ledit porte-lentille est de préférence fixé sur ledit support par une colle conductrice de l'électricité réalisant la liaison électrique entre eux.

Selon l'invention, ledit porte-lentille est de préférence muni d'une enveloppe ou couche extérieure en un matériau conducteur de l'électricité constituant sa partie de blindage.

Selon l'invention, lesdites parties de blindage portées par ledit support comprennent de préférence au moins un plan de blindage intégré s'étendant en dessous dudit composant optique et des colonnes intégrées débouchant sur la face frontale dudit support.

La présente ivention sera mieux comprise à l'étude de boîtiers semi-conducteurs optiques, décrits à titres d'exemples non limitatifs et illustrés par le dessin sur lequel :
- la figure 1 représente une coupe d'un premier boîtier semi-conducteur optique selon la présente invention ;
- la figure 2 représente une vue de dessus, porte-lentille et vitre enlevés, du boîtier semi-conducteur optique de la figure 1,
- la figure 3 représente une vue de dessus, porte-lentille enlevé, du boîtier semi-conducteur optique de la figure 1 ;
- la figure 4 représente une coupe d'un second boîtier semi-conducteur optique selon la présente invention ;
- la figure 5 représente un troisième boîtier semi-conducteur optique selon la présente invention ;
- et la figure 6 représente un quatrième boîtier semi-conducteur optique selon la présente invention.

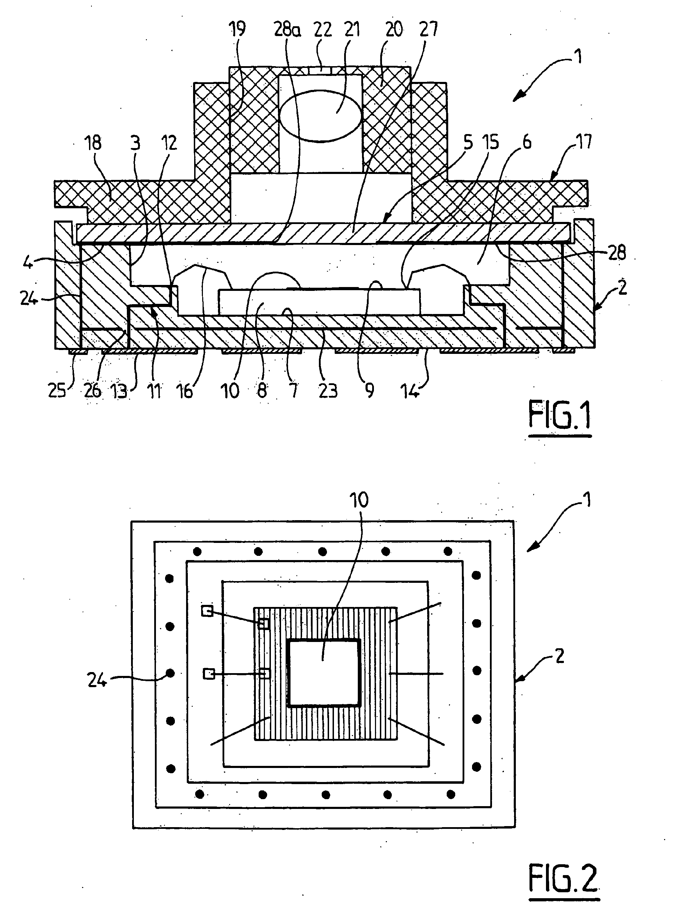

En se reportant aux figures 1 à 3, on voit qu'on a représenté un boîtier semi-conducteur optique 1 qui comprend un support 2 de forme parallélipipédique et plat, dans une face duquel est ménagé un évidement en creux 3, de telle sorte que ce support 2 présente, autour de cet évidement, une face frontale annulaire 4.

Ce boîtier optique 1 comprend un couvercle vitré 5 dont la périphérie de la face arrière est en appui et fixée contre la face frontale 4 du support 2, par exemple par une colle. Ainsi, le support 2 et le couvercle vitré 5 délimitent une cavité étanche d'encapsulation 6.

Dans la cavité 6 est disposé un composant semi-conducteur optique 8. La face arrière du composant optique 8 est fixée par exemple par une colle, contre le fond 7 de l'évidement 3 et sa face avant 9, qui s'étend à distance et parallèlement au couvercle vitré 5, présente dans sa partie centrale un capteur optique 10 couvrant par exemple une zone carrée.

Le support 2, constitué par exemple en une matière organique ou céramique multi-couches, présente un réseau interne 11 d'interconnexions électriques. Ce réseau 11 relie des plots internes 12 placés et répartis sur la paroi de l'évidement 3 du support 2, à distance et à la périphérie du composant optique 8, et des plots externes 13 de connexion électrique extérieure placés et répartis sur la face arrière 14 du support 2.

Le composant optique 8 présente sur sa face avant 9, à faible distance de sa périphérie et à distance du capteur optique 10, des plots avant 15 de connexion électrique.

Les plots internes 12 du support 2 et les plots avant 15 du composant optique 9 sont reliés par des fils électriques 16 dont les extrémités sont soudées sur ces plots. Le composant optique 8 peut ainsi être relié à un organe électrique extérieur au travers du support 2, via le réseau 11 et les fils électriques 16.

Le boîtier optique 1 comprend en outre un porte-lentille 17, extérieur à la cavité 6, qui comprend un plateau annulaire 18 fixé par exemple par collage sur la face avant du couvercle vitré 5. Dans l'ouverture centrale 19 du plateau 18 est montée une bague 20 par l'intermédiaire d'un filetage, cette bague 20 portant, dans son passage, une lentille optique 21 placée en face du capteur optique 10. La partie avant de la rondelle 20 détermine un diaphragme 22.

Ainsi, la lumière extérieure traverse le diaphragme 22, la lentille 21 et la vitre 27, au travers de l'ouverture 28a, pour atteindre le capteur optique 10 du composant optique 8.

Le boîtier optique 1 comprend en outre des moyens de blindage électromagnétique électriquement isolés du réseau de connexions électriques 11 du support 2 et constitués de la manière suivante.

Le support 2 comprend un plan intégré 23 en un matériau conducteur de l'électricité, par exemple métallique, qui s'étend parallèlement à sa face arrière 14 et une multiplicité de colonnes intégrées 24 en un matériau conducteur de l'électricité, par exemple métallique, qui sont répartis dans le volume périphérique du support 2 et qui sont reliés au plan conducteur 23. Ces colonnes conductrices 24 débouchent sur la face frontale 4 du support 2 et au moins une de ces colonnes débouchent sur la face arrière 14 du support 2 de façon à constituer au moins un plot de connexion électrique extérieure 25.

Dans le support 2, le plan conducteur intégré 23 et les colonnes conductrices intégrées 24 sont agencés de façon à ne pas être en contact avec le réseau intégré d'inter-connexion 11. En particulier, le plan conducteur 23 présente des passages traversants 26 au travers desquels passent les lignes d'interconnexion du réseau 11.

Le couvercle vitré 5 comprend une vitre transparente 27 dont la face arrière est munie d'une couche 28 en un matériau conducteur de l'électricité, sauf dans sa partie centrale située en face du capteur optique 10 du composant optique 8 de façon à laisser un passage 28a pour la lumière.

Sur la face arrière du couvercle vitré 5 est fixée par l'intermédiaire d'une colle annulaire conductrice de l'électricité sur la face frontale 4 du support 1, de telle sorte que la couche conductrice 28 est électriquement reliée aux colonnes conductrices intégrées 24, le plateau 18 du porte-lentille 17 étant fixé par collage sur la face avant de la vitre 27.

Il résulte de ce qui précède qu'en reliant le plot extérieur 25 à une masse, de préférence indépendante de la masse du composant optique, les moyens de blindage constitués par le plan conducteur 23, les colonnes conductrices 24 et la couche conductrice 28 constituent une cage d'isolation électromagnétique du composant semi-conducteur optique 8.

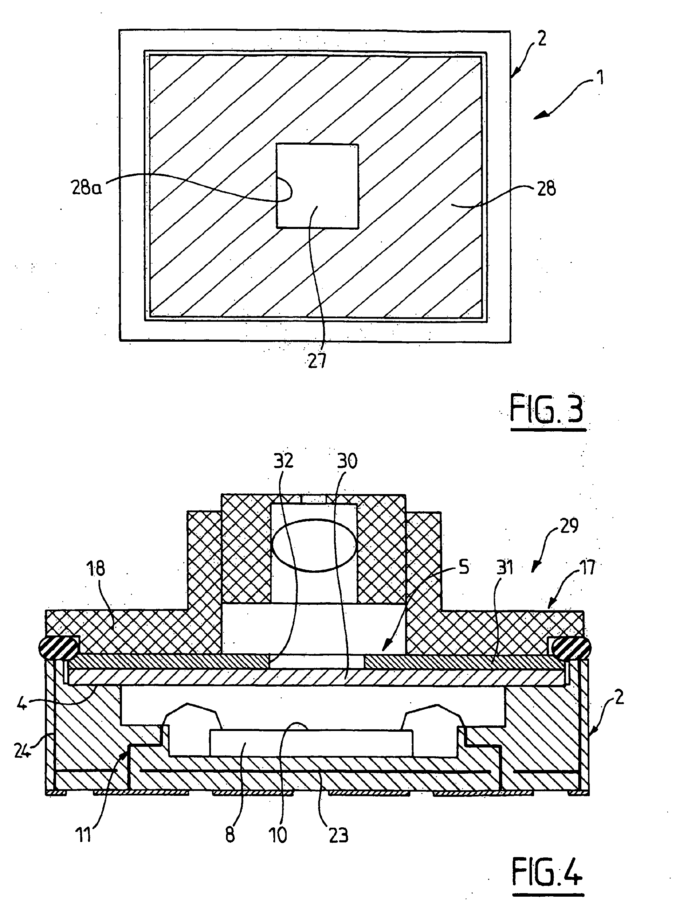

En se reportant à la figure 4, on voit qu'on a représenté un boîtier semi-conducteur optique 29 qui se différencie du boîtier semi-conducteur optique 1 de la manière suivante.

Son couvercle vitré 5 comprend une vitre transparente 30 dont la périphérie est en appui sur la face frontale 4 du support 2 et une couche ou une plaque 31 en un matériau conducteur de l'électricité, placée entre la face avant de la vitre 30 et la face arrière du porte-lentille 17 et présentant une ouverture ou passage 32 situé en face du capteur optique 10 du composant optique 8.

Les colonnes conductrices 24 du support 2 débouchent en-dessous de la partie périphérique du plateau 18 du porte-lentille 17, périphériquement au couvercle vitré 5. Le porte-lentille 17 est fixé au support 2 par l'intermédiaire d'une colle annulaire conductrice de l'électricité assurant en outre une liaison électrique entre la couche ou plaque conductrice 31 et les colonnes conductrices intégrées 24.

Dans cet exemple, le plan conducteur 23, les colonnes conductrices 24 et la couche ou plaque conductrice 31 constituent une cage d'isolation électromagnétique du composant semi-conducteur optique 8.

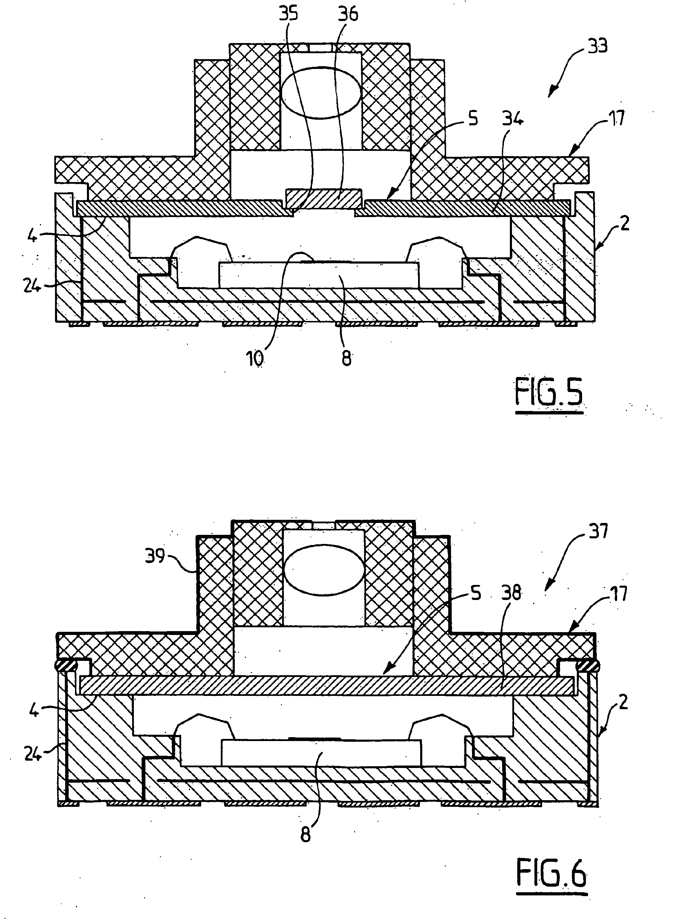

En se reportant à la figure 5, on voit qu'on a représenté un boîtier semi-conducteur optique 33 qui se différencie du boîtier optique 1 décrit en référence aux figures 1 à 3 de la manière suivante.

Le couvercle vitré 5 comprend une plaque 34 en un matériau conducteur de l'électricité dont la partie périphérique de la face arrière est fixée, par une colle annulaire conductrice de l'électricité, sur la face frontale 4 du support 2 de façon à être reliée électriquement aux colonnes conductrices intégrées 24 de ce support 2.

La plaque conductrice 34 présente une ouverture ou passage 35 obstruée par une vitre transparente 36 située en face du capteur optique 10 du composant optique 8.

Le porte-lentille 17 est fixé par l'intermédiaire d'une colle sur la face avant de la plaque conductrice 34.

Dans cet exemple, le plan conducteur intégré 23, les colonnes conductrices 24 et la plaque conductrice 34 constituent une cage d'isolation électromagnétique du composant optique 8.

En se reportant à la figure 6, on voit qu'on a représenté un boîtier semi-conducteur optique 37 qui se différencie du boîtier semi-conducteur optique 29 décrit en référence à la figure 4 de la manière suivante.

Le couvercle vitré 5 comprend uniquement une vitre transparente 38 interposée entre la face arrière du porte-lentille 17 et la face frontale 4 du support 2.

Les faces extérieures de ce porte-lentille 17 sont recouvertes d'une couche 39 en un matériau conducteur de l'électricité, reliée électriquement aux colonnes conductrices intégrées 24 du support 2 par l'intermédiaire de la colle annulaire conductrice de l'électricité fixant le support 2 au porte-lentille 17.

Dans cet exemple, le plan conducteur intégré 23, les colonnes conductrices intégrées 24 et la couche conductrice 39 constituent une cage d'isolation électromagnétique du composant semi-conducteur 8.

La présente invention ne se limite pas aux exemples ci-dessus décrits. Bien des variantes de réalisation sont possibles sans sortir du cadre défini par les revendications annexées.

## Revendications

1. Boîtier semi-conducteur optique comprenant un composant semi-conducteur optique (8) dont une face avant présente un capteur optique et des moyens d'encapsulation (2,5,17) comprenant un support (2) et un couvercle (5) disposé sur une face frontale de ce support, qui délimitent entre eux une cavité (6) dans laquelle est disposé ledit composant optique dont la face arrière est fixée sur ledit support, et présentant des moyens de connexion électrique extérieure (13) de ce composant semi-conducteur optique, ledit couvercle comprenant une vitre (27) laissant passer la lumière vers ledit capteur optique, lesdits moyens d'encapsulation comprenant des moyens de blindage électromagnétique (23,24,28,31,34,39) en un matériau conducteur de l'électricité, ces moyens de blindage étant isolés électriquement des moyens de connexion électrique dudit composant optique, une zone (28a) desdits moyens d'encapsulation située en face dudit capteur optique (10) étant exempte de moyens de blindage électromagnétique afin de laisser passer la lumière vers ce capteur,
**caractérisé par le fait que** lesdits moyens de blindage (23, 24, 28, 31, 34, 39) sont reliés à des moyens de connexion électrique extérieure (25) et comprennent des parties de blindage (23, 24) portées par ledit support (2) et des parties de blindage (28, 31, 34) portées par ledit couvercle (5), ces parties de blindage étant reliées électriquement entre elles dans la zone de la face frontale dudit support.

2. Boîtier selon la revendication 1, **caractérisé par le fait que** lesdits moyens de blindage sont au moins en partie intégrés dans lesdits moyens d'encapsulation.

3. Boîtier selon la revendication 1, **caractérisé par le fait que** lesdits moyens de blindage enveloppe au moins en partie lesdits moyens d'encapsulation.

4. Boîtier selon l'une quelconque des revendications précédentes, **caractérisé par le fait que** ledit couvercle vitré (5) est fixé sur ledit support par une colle conductrice de l'électricité réalisant la liaison électrique entre eux.

5. Boîtier selon l'une quelconque des revendications précédentes, **caractérisé par le fait que** ledit couvercle vitré comprend une vitre (27) dont une face est recouverte au moins partiellement d'une couche ou une plaque de blindage (28, 31) en un matériau conducteur de l'électricité ménageant une ouverture (28a, 32)) située en face dudit capteur optique.

6. Boîtier selon l'une quelconque des revendications 1 à 4, **caractérisé par le fait que** ledit couvercle vitré comprend une plaque (34) en un matériau conducteur de l'électricité, qui présente une ouverture (35) située en face dudit capteur optique et obstruée par ladite vitre (36).

7. Boîtier selon l'une quelconque des revendications précédentes, lesdits moyens d'encapsulation comprenant un porte-lentille (17) placé en avant dudit couvercle vitré, **caractérisé par le fait que** lesdits moyens de blindage comprennent parties de blindage (39) portées par ledit porte-lentille (17).

8. Boîtier selon la revendication 7, **caractérisé par le fait que** ledit porte-lentille (17) est fixé sur ledit support (2) par une colle conductrice de l'électricité réalisant la liaison électrique entre eux.

9. Boîtier selon l'une des revendications 7 et 8, **caractérisé par le fait que** ledit porte-lentille (17) est muni d'une enveloppe ou couche extérieure (39) en un matériau conducteur de l'électricité constituant sa partie de blindage.

10. Boîtier selon l'une , quelconque des revendications précédentes, **caractérisé par le fait que** lesdites parties de blindage portées par ledit support comprennent au moins un plan de blindage intégré (23) s'étendant en dessous dudit composant optique et des colonnes intégrées (24) débouchant sur la face frontale (4) dudit support.

## Claims

1. Optical semiconductor package comprising an optical semiconductor component (8), a front face of which has an optical sensor, and encapsulation means (2, 5, 17) comprising a support (2) and a lid (5) placed over a front face of this support, which between them define a cavity (6) in which the said optical component, the rear face of which is fastened to the said support, is placed and having means (13) for the external electrical connection of this optical semiconductor component, the said lid including a glass pane (27) letting light through to the said optical sensor, the said encapsulation means comprising electromagnetic screening means (23, 24, 28, 31, 34, 39) made of an electrically conductive material, these screening means being electrically isolated from the means for the electrical connection of the said optical component, a region (28a) of the said encapsulation means which is situated facing the said optical sensor (10) being devoid of electromagnetic screening means so as to let the light through to this sensor,
**characterized in that** the said screening means (23, 24, 28, 31, 34, 39) are connected to means (25) for external electrical connection and comprise screening parts (23, 24) carried by the said support (2) and screening parts (28, 31, 34) carried by the said lid (5), these screening parts being electrically connected together in the region of the front face of the said support.

2. Package according to Claim 1, **characterized in that** the said screening means are at least partly integrated into the said encapsulation means.

3. Package according to Claim 1, **characterized in that** the said screening means at least partly envelop the said encapsulation means.

4. Package according to any one of the preceding claims, **characterized in that** the said glazed lid (5) is fastened to the said support by an electrically conductive adhesive making the electrical connection between them.

5. Package according to any one of the preceding claims, **characterized in that** the said glazed lid comprises a glass pane (27), one face of which is at least partly covered with a screening layer or plate (28, 31) made of an electrically conductive material, leaving an opening (28a, 32) facing the said optical sensor.

6. Package according to any of Claims 1 to 4, **characterized in that** the said glazed lid comprises a plate (34) made of an electrically conductive material, which has an opening (35) facing the said optical sensor and is obstructed by the said glass pane (36).

7. Package according to any one of the preceding claims, the said encapsulation means comprising a lens holder (17) placed in front of the said glazed lid, **characterized in that** the said screening means comprise screening parts (39) carried by the said lens holder (17).

8. Package according to Claim 7, **characterized in that** the said lens holder (17) is fastened to the said support (2) by an electrically conductive adhesive making the electrical connection between them.

9. Package according to either of Claims 7 and 8, **characterized in that** the said lens holder (17) is provided with an outer envelope or layer (39) made of an electrically conductive material constituting its screening part.

10. Package according to any one of the preceding claims, **characterized in that** the said screening parts carried by the said support comprise at least one integrated screening plane (23) extending beneath the said optical component and integrated columns (24) emerging on the front face (4) of the said support.

## Patentansprüche

1. Optisches Halbleiter-Gehäuse aufweisend
ein optisches Halbleiterbauelement (8), dessen vordere Fläche einen optischen Sensor aufweist, und
Verkapselungseinrichtungen (2,5,17), die einen Träger (2) und einen auf einer Stirnseite dieses Trägers angeordneten Deckel (5) aufweisen, die zwischen sich einen Hohlraum (6) umgrenzen, in welchem das optische Bauelement angeordnet ist, dessen hintere Fläche an dem Träger angebracht ist, und
Einrichtungen (13) zur externen elektrischen Verbindung dieses optischen Halbleiterbauelements,
wobei der Deckel eine Glasscheibe (27) aufweist-, die das Licht zu dem optischen Sensor durchläßt,
wobei die Verkapselungseinrichtungen Einrichtungen (23,24,28,31,34,39) zur elektromagnetischen Abschirmung aus einem elektrisch leitenden Material aufweisen, wobei diese Abschirmungseinrichtungen elektrisch von den elektrischen Verbindungseinrichtungen des optischen Bauelements isoliert sind, wobei eine dem optischen Sensor (10) gegenüberliegende Zone (28a) der Verkapselungseinrichtungen ohne elektromagnetische Abschirmungseinrichtungen ist, um das Licht zu diesem Sensor durchzulassen,
**dadurch gekennzeichnet, daß** die Abschirmungseinrichtungen (23,24,28,31,34,39) mit externen elektrischen Verbindungseinrichtungen (25) verbunden sind und von dem Träger (2) gehaltene Abschirmungsabschnitte (23,24) und von dem Deckel (5) gehaltene Abschirmungsabschnitte (28,31,34) aufweisen, wobei in der Zone der Stirnfläche des Trägers diese Abschirmungsabschnitte elektrisch miteinander verbunden sind.

2. Gehäuse nach Anspruch 1, **dadurch gekennzeichnet, daß** die Abschirmungseinrichtungen zumindest teilweise in den Verkapselungseinrichtungen integriert sind.

3. Gehäuse nach Anspruch 1, **dadurch gekennzeichnet, daß** die Abschirmungseinrichtungen mindestens einen Teil der Verkapselungseinrichtungen umhüllen.

4. Gehäuse nach einem der vorstehenden Ansprüche, **dadurch gekennzeichnet, daß** der Glasdeckel (5) mittels eines elektrisch leitenden Klebstoffs an dem Träger angebracht ist, wobei der Klebstoff die elektrische Verbindung zwischen ihnen bildet.

5. Gehäuse nach einem der vorstehenden Ansprüche, **dadurch gekennzeichnet, daß** der Glasdeckel ein Glas (27) aufweist, von welchem eine Fläche zumindest teilweise mit einer Abschirmungsschicht oder einer Abschirmungsplatte (28,31) aus einem elektrisch leitenden Material bedeckt ist, in welcher eine Öffnung (28a,32), die dem optischen Sensor gegenüberliegt, ausgespart ist.

6. Gehäuse nach einem der Ansprüche 1 bis 4, **dadurch gekennzeichnet, daß** der Glasdeckel eine Platte (34) aus einem elektrisch leitenden Material aufweist, die eine Öffnung (35) aufweist, die dem optischen Sensor gegenüberliegt und durch das Glas (36) versperrt ist.

7. Gehäuse nach einem der vorstehenden Ansprüche, wobei die Verkapselungseinrichtungen einen vor dem Glasdeckel angeordneten Linsenhalter (17) aufweisen, **dadurch gekennzeichnet, daß** die Abschirmungseinrichtungen von dem Linsenträger (17) gehaltene Abschirmungsabschnitte (39) aufweisen.

8. Gehäuse nach Anspruch 7, **dadurch gekennzeichnet, daß** der Linsenhalter (17) mittels eines elektrisch leitenden Klebstoffs an dem Träger angebracht ist, wobei der Klebstoff die elektrische Verbindung zwischen ihnen bildet.

9. Gehäuse nach einem der Ansprüche 7 und 8, **dadurch gekennzeichnet, daß** der Linsenhalter (17) mit einer Hülle oder äußeren Schicht (39) aus einem elektrische leitenden Material versehen ist, die seinen Abschirmungsabschnitt bildet.

10. Gehäuse nach einem der vorstehenden Ansprüche, **dadurch gekennzeichnet, daß** die von dem Träger gehaltenen Abschirmungsabschnitte mindestens eine integrierte Abschirmungsebene (23), die sich unterhalb des optischen Bauelements erstreckt, und integrierte Säulen (24) aufweisen, die zu der Stirnseite (4) des Trägers führen.
